Europäisches Patentamt

European Patent Office

Office européen des brevets

(11) Publication number: **0 427 249 A2**

# EUROPEAN PATENT APPLICATION

(21) Application number: 90121344.7

(51) Int. Cl.5: **G03F 7/027**, G03F 7/029

(22) Date of filing: 08.11.90

(30) Priority: 09.11.89 US 435830

(43) Date of publication of application:
15.05.91 Bulletin 91/20

(84) Designated Contracting States:
AT BE CH DE DK ES FR GB GR IT LI LU NL SE

(71) Applicant: E.I. DU PONT DE NEMOURS AND COMPANY
1007 Market Street
Wilmington Delaware 19898(US)

(72) Inventor: Lee, Shung-Yan Luke
2716 Marklyn Drive
Wilmington, Delaware 19810(US)

(74) Representative: Werner, Hans-Karsten, Dr. et al
Deichmannhaus am Hauptbahnhof
W-5000 Köln 1(DE)

(54) **Aqueous processible photopolymerizable compositions capable of photolytically generating metal ions.**

(57) Improved properties are obtained with aqueous processible photosensitive compositions by use of a combination of a metal compound and an acid precursor. The metal compound is capable of generating multivalent metal ions with a strong acid, which is generated from the acid precursor during imagewise irradiation of the photosnesitive composition.

EP 0 427 249 A2

# AQUEOUS PROCESSIBLE PHOTOPOLYMERIZABLE COMPOSITIONS CAPABLE OF PHOTOLYTICALLY GENERATING METAL IONS

## BACKGROUND OF THE INVENTION

The present invention relates to photosensitive compositions which contain additives useful for affecting the processibility of the compositions in a basic aqueous solution and also useful for improving end-use performance of dry film photoresists prepared from the compositions.

Photosensitive compositions particularly useful as photoresists are well known in the prior art. Conventionally these compositions are stored in roll form. The composition is adhered to a support film to form a two ply material such as disclosed in U.S. Patent 4,293,635 or more conventionally in a three ply material such as U.S. Patent 3,469,982 with the composition sandwiched between a support film and a coversheet. The photosensitive composition contains components of monomer, initiator and a polymeric binder which allows such composition to be negative working, (i.e., exposure to actinic radiation hardens the film to make the exposed portion insoluble in a developer solution). The material is conventionally unwound from a roll, and the cover sheet if present is removed from contact with the photosensitive composition prior to use in lamination to a substrate, e.g., in manufacture of printed circuit boards. The laminated composition is exposed imagewise to actinic radiation with a support film stripped from the photosensitive composition before or after the exposure step. The unexposed areas of the starting light-sensitive layer are washed away in a development step to form a resist image of polymeric material. The uncovered portion of the substrate is conventionally etched or plated followed by removal of the polymeric resist image.

Aqueous processible photopolymerizable compositions are well known in the art and offer significant advantages to the printed circuit industry in terms of lower costs and environmental safeguards. Aqueous processibility, commonly known as development, is the ability of the unexposed photopolymerizable composition to be removed by a basic aqueous solution while the material resulting from the polymerization of the composition has the ability to withstand removal. Acid containing polymeric binders have played an important role in the production of such compositions which allow development in basic aqueous solutions.

Photosensitive compositions which contain metal compounds are well known in the prior art. U.S. Patent 4,272,608 discloses incorporation of a metal compound to provide ionic crosslinking of the polymeric binder which is a high molecular weight carboxylated butadiene/acrylonitrile copolymer having a number average molecular weight in the range from about 20,000 to 75,000 and carboxyl content of about 2 to about 15% by weight. The ionic crosslinks are formed during mixing of the ingredients and are thus present in both exposed and unexposed regions. The metal compounds disclosed in this patent include metal alkoxides, metal hydroxides, metal oxides, metal salts of relatively weak carboxylic acids, e.g., metal acetates including zinc acetate, etc., metal salts of an acid readily eliminated from the crosslinking site and metal acetoacetates and acetylacetonates. Additionally various metal organic compounds are known as catalysts or accelerators in photosensitive resist compositions. U.S. Patent 3,656,951 discloses using a class of metal salts of organic acids. Metal cations include zinc, copper, tin, cobalt, manganese, cerium, molybdenum, iron, nickel, cadmium, magnesium, lead, silver, calcium and sodium. The organic acids include higher fatty acids such as oleic, octanoic, naphthenic, and stearic. Also useful are metallic chelates and enolates, such as acetylacetonates of the above metals. U.S. Patent 3,847,768 discloses a radiation curable coating composition containing a curing accelerator of the formula $M(NH_4)PO_4 \cdot nH_2O$ wherein M is magnesium, calcium or strontium and n is 0 or a positive integer from 1-10.

## SUMMARY OF THE INVENTION

The present invention is related to a photopolymerizable composition comprising:

(a) at least one nongaseous ethylenically unsaturated compound having a boiling point above $100°$ C at normal atmospheric pressure and being capable of forming a high polymer by photoinitiated addition polymerization,

(b) an initiating system activated by actinic radiation, and

(c) a preformed macromolecular acid binder containing carboxylic acid groups, whereby the composition is capable of development in an aqeuous sodium carbonate solution containing one percent by weight sodium carbonate, said development allowing removal of the photopolymerizable composition without removal of a photopolymerized material resulting from the photopolymerizable composition wherein the improvement comprises incorporation into said composition a substantially insoluble metal compound and a precursor to an acid whereby the precursor will photolytically form an acid upon exposure of said composition to actinic radiation of sufficient intensity and duration to polymerize said composition, whereby the metal compound reacts with the photolytically generated acid to form soluble multivalent metal ions which are capable of reacting with the carboxylic acid groups of the binder.

## DETAILED DESCRIPTION OF THE INVENTION

The ingredients for the photosensitive compositions of the present invention, which are formulated and coated as a dry film on a flexible backing material, are well known in the prior art with the exception of the combination of a precursor to an acid and an insoluble or inactive metal compound in which said metal compound will react in the presence of acid photogenerated from the precursor to provide active multivalent metal ions. It has been found that the active multivalent ions, photogenerated concurrent with polymerization exposure of the composition, can improve the following end-use properties of the photopolymerized resist material: alkaline etchant resistance, tenting strength and development latitude.

The photosensitive compositions herein, in the same way as photosensitive compositions of the prior art, are intended to be imagewise exposed to actinic radiation with the result that those portions of the composition struck by actinic radiation will be polymerized. The unexposed areas are removed with a dilute basic aqueous solution while the exposed areas have a resistance to such solution. With increasing resistance to alkaline solutions, an important advantage is imparted, namely the ability of the polymerized portions of the material to withstand subsequent contact with alkaline etchants used to remove uncovered copper in circuit board preparation. This can directly translate into an ability to resist undercutting, i.e., preventing the alkaline etchant from attacking the polymerized portions at their interface with the copper substrate. Such undercutting is highly undesirable since it can introduce a defect in the final printed circuit board. Surprisingly, and beneficially, this improvement in alkaline etchant resistant does not increase resist stripping time in the KOH solution widely used. Along with improved alkaline etch resistance of the compositions of this invention, development latitude is increased. In other words, a wide range of development conditions can be utilized to remove the original photosensitive composition which has not been polymerized without adversely affecting the polymerized portions. Therefore, less careful control of processing conditions can be tolerated. The generation of active multivalent cations during exposure also improves tenting strength of the polymerized layer. This means that in preparing circuit boards containing plated-through-holes, resists made from compositions of this invention will offer better protection during the development and etching steps thereby allowing use of the resist to make boards having larger diameter holes and resulting in higher yields of acceptable boards in manufacturing operations.

In the present invention multivalent metal ions must be generated in situ during the exposure of the photopolymerizable composition to actinic radiation. This exposure to actinic radiation of sufficient intensity and duration to polymerize the composition also creates strong acid from the acid precursor present in the composition. This acid then reacts with the insoluble or inactive metal compound present to create active multivalent metal ions which are capable of reacting with the carboxylic acid groups on the acidic binder. These multivalent ions are thus capable of ionically crosslinking the binder which is considered to account for the improved alkaline etchant resistance with an attendant increase in development latitude and tenting ability.

The metal compounds are substantially insoluble or inactive in the photopolymer formulation and must have the ability to react with acid in order to create the soluble or active multivalent metal ions. By insoluble or inactive metal compounds, it is meant that during storage at room temperature overnight or for 3-4 days the metal compounds do not significantly increase the viscosity of nor gel the coating mixtures containing them by reacting with the carboxyl groups present on the polymeric binders dissolved therein. Also it is meant that coated dry films containing the metal compounds will not begin to gel or crosslink on storage at room temperature for periods of a few days to a month or greater. This absence of film crosslinking will be noted as no significant change in "time to clean", i.e., the minimum time in alkaline developer needed to remove all unexposed material from a panel laminated with a film of this invention. Complete removal means leaving no film residue in the areas uncovered by development that could retard or prevent subsequent etching or plating in such areas. Useful metal ions which can be employed in the present invention include aluminum, calcium, magnesium, and barium. Each of these ions is capable of reacting with a carboxylic acid moiety. Examples of insoluble metal compounds which can be employed in the present invention as a fine dispersion in the photosensitive composition include calcium carbonate, barium oxide, magnesium sulfate and aluminum oxide. Without being bound to any limitation it is considered that 0.05% to 20% by weight and more preferably in the range of 2.5% to 10% of the metal compound be present in the photosensitive composition.

It is a further requirement that the composition incorporates a precursor to an acid whereby the precursor will photolytically form an acid under the conditions of exposure of actinic radition normally used to cause polymerization of the composition. It is necessary that acid is formed under these conditions of exposure to actinic radiation since otherwise the purpose of the present invention will be defeated. Excessive generation of acid prior to such exposure due to precursor instability is undesirable since premature crosslinking will occur. Examples of stable precursors which can generate acid photolytically include hexafluorophosphate and sulfonate compounds such as those which can photolytically form hexafluorophosphoric acid or sulfonic acid. Weaker acids than these can be employed provided they meet conditions of the present invention namely the ability to be photolytically formed and the ability to react with the metal compound to create the metal ions in situ. Examples of acid-precursors which can be employed in the present invention include diphenyliodonium hexafluorophosphate, triphenylsulfonium hexafluorophosphate and sulfonyloxy ketones. Without being bound to any limitation it is considered that at least 0.025 by weight and more preferably in the range of 1% to 5% of acid-precursor be present in the photosensitive composition.

As previously described the remaining constituents of the photopolymerizable composition are conventional in the prior art with the requirement that aqueous processibility is present. In this context aqueous processibility means the photosensitive composition can be removed in an aqueous solution containing one percent sodium carbonate by weight. This means that the solution at a temperature of $40^{\circ}$ during a time period of one or more minutes will remove areas of the composition which have not been exposed to actinic radiation but will not remove exposed areas. Typical of such photopolymerizable compositions are those disclosed in U.S. Patent 4,273,857, U.S. Patent 4,293,635, U.S. Patent 3,887,450 and U.S. Patent 4,239,844. It is understood that in actual development that other basic aqueous solutions may be employed in a conventional manner.

In order for aqueous developability in a weakly basic solution it is necessary that the beginning photopolymerizable composition contain an acid binder which contains carboxylic acid group moieties. Acid binders are well-known in photopolymerizable compositions and they may be synthesized or one or more of the many commercially available polymers may be employed. The binder should be of sufficient acidity to render the composition processible and aqueous developable and should have sufficient reactivity to undergo the reaction with the multivalent metal ion. Useful examples of aqueous processible binders include those disclosed in U.S. Patent 4,273,857, U.S. Patent 3,458,311, German Patent 2,123,702 and U.K. Patent 1,507,704.

Without being bound to any limitation it is considered that combination of acid number and a pKa value can be employed in determining which acid binders are highly preferred. Generally an acid number of at least 50 and more preferably in the range of 80 to 400 will be employed while a pKa value not greater than 11 and more preferably in the range of 11 to 5 will be utilized. The pKa value is generally measured in acetone. Acid binders with a high acid number and a high pKa value generally require a higher percentage of metal compound in the composition. Acid binders with a low acid number and low pKa smaller percentages of metal compound.

Suitable binders which can be used as the sole binder or in combination with others include those disclosed in U.S. Patent 4,273,857; U.S. Patent 3,458,311; U.S. Patent 4,293,635; U.S. Patent 4,239,844; U.S. Patent 3,887,450; German Patent 2,123,702 and U.K. Patent 1,507,704 as well as the following with the proviso that at least one of the binders used is an acid binder as described above: polyacrylate and alphaalkyl polyacrylate esters, e.g., polymethyl methacrylate and polyethyl methacrylate; polyvinyl esters, e.g., polyvinyl acetate, polyvinyl acetate/acrylate, polyvinyl acetate/methacrylate and hydrolyzed polyvinyl acetate; ethylene/vinyl acetate copolymers; polystyrene polymers and copolymers, e.g., with maleic anhydride and esters; vinylidene chloride copolymers, e.g., vinylidene chloride/acrylonitrile; vinylidene chloride/methacrylate and vinylidene chloride/vinyl acetate copolymers, polyvinyl chloride and copolymers, e.g., polyvinyl chloride/acetate; saturated and unsaturated polyurethanes; synthetic rubbers, e.g., butadiene/acrylonitrile, acrylonitrile/butadiene/styrene, methacrylate/acrylonitrile/butadiene/styrene copolymers, 2-chlorobutadiene-1,3 polymers, chlorinated rubber, and styrene/butadiene/styrene, styrene/isoprene/styrene block copolymers; high molecular weight polyethylene oxides of polyglycols having average molecular weights from about 4,000 to 1,000,000; epoxides, e.g., epoxides containing acrylate or methacrylate groups; copolyesters, e.g., those prepared from the reaction product of a polymethylene glycol of the formula $HO(CH_2)_nOH$, where n is a whole number 2 to 10 inclusive, and (1) hexahydroterephthalic, sebacic and terephthalic acids, (2) terephthalic, isophthalic and sebacic acids, (3) terephthalic and sebacic acids, (4) terephthalic and isophthalic acids, and (5) mixtures of copolyesters prepared from said glycols and (i) terephthalic, isophthalic and sebacic acids and (ii) terephthalic, isophthalic, sebacic and adipic acids; nylon or polyamides, e.g., N-methoxymethyl polyhexamethylene adipamide; cellulose esters, e.g., cellulose acetate, cellulose acetate succinate and cellulose acetate butyrate; cellulose esters, e.g., methyl cellulose, ethyl cellulose and benzyl cellulose; polycarbonates; polyvinyl acetal, e.g., polyvinyl butyral, polyvinyl formal; polyformaldehydes.

Suitable monomers which can be used as the sole monomer or in combination with others include the following: t-butyl acrylate, 1,5-pentanediol diacrylate, N,N-diethylaminoethyl acrylate, ethylene glycol diacrylate, 1,4-butanediol diacrylate, diethylene glycol diacrylate, hexamethylene glycol diacrylate, 1,3-propanediol diacrylate, decamethylene glycol diacrylate, decamethylene glycol dimethyacrylate, 1,4-cyclohexanediol diacrylate, 2,2-dimethylolpropane diacrylate, glycerol diacrylate, tripropylene glycol diacrylate, glycerol triacrylate, trimethylolpropane triacrylate, pentaerythritol triacrylate, polyoxyethylated trimethylolpropane triacrylate and trimethacrylate and similar compounds as disclosed in U.S. Patent No. 3,380,831, 2,2-di(p-hydroxyphenyl)-propane diacrylate, pentaerythritol tetraacrylate, 2,2-di-(p-hydroxyphenyl)-propane dimethacrylate, triethylene glycol diacrylate, polyoxyethyl-2,2-di(p-hydroxyphenyl)-propane dimethacrylate, di-(3-methacryloxy-2-hydroxpropyl) ether or bisphenol-A, di-(2-methacryloxyethyl) ether of bisphenol-A, di-(3-acryloxy-2-hydroxypropyl) ether of bisphenol-A, di-(2-acryloxyethyl) ether of bisphenol-A, di-(3-methacryloxy-2-hydroxypropyl) ether of tetrachloro-bisphenol-A, di-(2-methacryloxyethyl) ether of tetrachloro-bisphenol-A, di-(3-methacryloxy-2-hydroxypropyl) ether of tetrabromo-bisphenol-A, di-(2-methacryloxyethyl) ether of tetrabromo-bisphenol-A, di-(3-methacryloxy-2-hydroxypropyl) ether of 1,4-butanediol, di-(3-methacryloxy-2-hydroxypropyl) ether of diphenolic acid, triethylene glycol dimethacrylate, polyoxypropyltrimethylol propane triacrylate (462), ethylene glycol dimethacrylate, butylene glycol dimethacrylate, 1,3-propanediol dimethyacrylate, 1,2,4-butanetriol trimethyacrylate, 2,2,4-trimethyl-1,3-pentanediol dimethacrylate, pentaerythritol trimethylacrylate, 1-phenyl ethylene-1,2-dimethacrylate, pentaerythritol tetramethacrylate, trimethylol propane trimethacrylate, 1,5-pentanediol dimethacrylate, diallyl fumarate, styrene, 1,4-benzenediol dimethacrylate, 1,4-diisopropenyl benzene, and 1,3,5-triisopropenyl benzene.

In addition to the ethylically unsaturated monomers mentioned above, the layer can also contain at least one of the following free radical-initiated, chain-propagating, addition-polymerizable, ethylenically unsaturated compounds having a molecular weight of at least 300. Preferred momers of this type are an alkylene or a polyalkylene glycol diacrylate prepared from an alkylene glycol of 2 to 15 carbons or a polyalkylene ether glycol of 1 to 10 ether linkages, and those disclosed in U.S. Patent No. 2,927,022, e.g., those having a plurality of addition polymerizable ethylenic linkages particularly when present as terminal linkages. Especially preferred are those wherein at least one and preferably most of such linkages are conjugated with a double bonded carbon, including carbon double bonded to carbon and to such heteroatoms as nitrogen, oxygen and sulfur. Outstanding are such material wherein the ethylenically unsaturated groups, especially the vinylidene groups, are conjugated with ester or amide structures.

Preferred free radical-generating addition polymerization initiators activatable by actinic light and thermally inactive at and below 185° C include the substituted or unsubstituted polynuclear quinones which are compounds having two intracyclic carbon atoms in a conjugated carbocylic ring system, e.g. 9,10-anthraquinone, 1-chloroanthraquinone, 2-chloroanthraquinone, 2-methylanthraquinone, 2-ethylanthraquinone, 2-tert-butylanthraquinone, octamethylanthraquinone, 1,4-naphthoquinone, 9,10-phenanthrenequinone, 1,2-benzanthraquinone, 2,3-benzanthraquinone, 2-methyl-1,4-naphthoquinone, 2,3-dichloronaphthoquinone, 1,4-dimethylanthraquinone, 2,3-dimethylanthraquinone, 2-phenylanthraquinone, 2-3-diphenylanthraquinone, sodium salt of anthraquinone alpha-sulfonic acid, 3-chloro-2-methylanthraquinone, retenequinone, 7,8,9,10-tetrahydronaphthacenequinone, and 1,2,3,4-tetrahydrobenz(a)anthracene-7,12-dione. Other photoinitiators which are also useful, even though some may be thermally active at temperatures as low as 85° C, are described in U.S. Patent No. 2,760,863 and include vicinal ketaldonyl alcohols, such as benzoin, pivaloin, acyloin ethers, e.g., benzoin methyl and ethyl ethers; alpha-hydrocarbon-substituted aromatic acyloins, including alpha-methylbenzoin, alpha-allylbenzoin and alpha-phenylbenzoin. Photoreducible dyes and reducing agents disclosed in U.S. Patents: 2,850,445; 2,875,047; 3,097,096; 3,074,974; 3,097,097; and 3,145,104 as well as dyes of the phenazine, oxazine, and quinone classes; Michler's ketone, benzophenone, 2,4,5-triphenylimidazolyl dimers with hydrogen donors, and mixtures thereof as described in U.S. Patents: 3,427,161; 3,479,185; and 3,549,367 can be used as initiators. Also useful with photoinitiators and photoinhibitors are sensitizers disclosed in U.S. Patent No. 4,162,162.

Thermal polymerization inhibitors that can be used in photopolymerizable compositions are: p-methoxyphenol, hydroquinone, and alkyl and aryl-substituted hydroquinones and quinones, tert-butyl catechol, pyrogallol, copper resinate, naphthylamines, beta-naphthol, cuprous chloride, 2,6-di-tert-butyl-p-cresol,

5

phenothiazine, pyridine, nitrobenzene and dinitrobenzene, p-toluquinone and chloranil. Also useful for thermal polymerization inhibition are the nitroso compositions disclosed in U.S. Patent No. 4,168,982.

Various dyes and pigments maybe added to increase the visibility of the resist image. Any colorant used, however, should preferably be transparent to the actinic radiation used.

In the practice of the present invention, a variety of supports may be used for the resist element. A suitable support having a high degree of dimensional stability to temperature changes may be chosen from a wide variety of films composed of high polymers, e.g., polyamides, polyolefins, polyesters, vinyl polymers, and cellulose esters. A preferred support for the present invention is polyethylene terephthalate.

Also a cover sheet can be employed in conventional manner with the photopolymerizable material between the support and cover sheet. The cover sheet can have the same composition as the support provided the cover sheet releases more readily than the support from the photopolymerizable composition. The supported photopolymerizable composition is stored in roll form prior to use.

Once the photosensitive composition has been coated on a support it can be then laminated to a surface to serve as a photoresist. Copper is a preferred surface for the practice of the present invention.

In use of the photopolymerization element, it is unwound from a roll, the cover sheet is removed of and the supported photopolymerizable composition is laminated to a support substrate. Therefore with or without the support in place, the photopolymerizable layer is imagewise disposed (i.e., through a photomask) to actinic radiation, nonexposed areas of the photopolymerizable layer removed and the substrate is permanently modified by etching or plating where it is not covered by the layer which was once photopolymerizable.

A preferred use of composition characterized herein is as a photoresist or a solder mask such as in making a printed circuit board. Such techniques are conventional in the art employing a solid material, e.g., U.S. Patent 3,469,982. The process is directed to laminating a photosensitive composition to a substrate which is subsequently modified comprising the steps of:

(a) laminating to the substrate a supported solid photosensitive film,

(b) imagewise exposing the layer to actinic radiation,

(c) removing unexposed areas of the layer to form resist areas,

(d) permanently modifying areas of the substrate which are unprotected by the resist areas by etching the substrate or by depositing a material onto the substrate. The support is conventionally removed before or after the exposure step. The compositions of this invention are particularly useful when the substrate surface is modified using an alkaline etchant. In the case of solder mask utility the step of depositing a material can be by application of solder. In a utility not involving direct use as a solder mask in initial application to a substrate (which is conductive with copper preferred circuitry therein) the resist areas are removed after step (d) which is conventional.

The following examples serve to illustrate the practice of the present invention. All percentages, ratios and parts are by weight unless otherwise indicated.

## EXAMPLES

## EXAMPLE 1

### Sample Preparation

A stock solution with the formulation in Table I was prepared.

TABLE I

| STOCK SOLUTION 1 | |
|---|---|
| Ingredient | Amount (g) |
| Styrene/maleic anhydride (partially esterified with isobutyl alcohol, Acid No. 210, Mol. Wt. 200,000 | 111.90 |
| Methyl methacrylate/ethyl acrylate/ acrylic acid (37/55/8), Acid No. 80, Mol. Wt. 260,000 | 21.00 |
| Methyl methacrylate/ethyl acrylate/ acrylic acid (71/17/12), Acid No. 100, Mol. Wt. 200,000 | 39.30 |
| Trimethylolpropane triacrylate | 24.30 |
| Triethyleneglycol dimethacrylate | 6.00 |
| Ethoxylated trimethylolpropane triacrylate | 36.37 |
| Michler's ketone | 0.45 |
| Benzophenone | 15.00 |
| 2,2'-Bis-(o-chlorophenyl-4,4',5,5' tetraphenylbiimidazole) | 1.20 |
| 2-Mercaptobenzoxazole | 0.60 |
| Benzotriazole | 1.20 |
| Leuco crystal violet | 0.75 |
| Sodium dioctylsulfosuccinate | 12.00 |
| Polyoxyethylene/propylene liquid oligomer, Mol. Wt. 3200 | 27.00 |
| 1,2,2-trimethyl-2,3-diazabicyclo-[3.2.2]-non-2-ene N,N'-dioxide | 0.09 |
| N,N-Diethylhydroxylamine | 0.90 |
| 1-Hydroxyethyl-2-heptyl-imidazoline | 1.50 |
| Victoria Green dye | 0.12 |
| Victoria Blue dye | 0.09 |
| Methylene chloride | 469.48 |
| Methanol | 40.82 |

To an aliquot of the stock solution other components were added to make the coating mixtures in Table II. Ceramics rods were added to mixture 1B to break up clumps of $CaCO_3$ and removed before coating. The mixtures were placed on a roll mill and slowly rotated overnight. Each mixture was coated on 0.001 inch (25.4 microns) polyethylene terephthalate film using a 0.006 inch (152 microns) doctor knife and air dried. A protective cover film of 0.001 inch (25.4 microns) polyethylene was then applied. The thickness of the dry coatings was about 0.0013 inch (33 microns).

TABLE II

| COATING MIXTURES | | | |
|---|---|---|---|
| Ingredient | 1A | 1B | 1C |
| Stock solution 1 | 262.00 g | 270.00 g | 270.00 g |
| Diphenyliodonium hexafluorophosphate | --- | 1.26 g | --- |
| MultifLex® MM calcium carbonate (1) | --- | 5.40 g | --- |
| Calcium acetoacetonate | --- | --- | 0.27 g |

(1) Purity >97%, average particle size 0.07 micron. Pfizer Inc., Adams, MA

The coatings were laminated with a Riston® HRL Laminator[3] set at 105°C and 3 ft/min (0.914 m/min) to copper clad glass-epoxy boards. The laminated samples were imagewise exposed on a Riston® P-130 Exposure Unit [2] and developed in a Riston® ADS-24 Aqueous Developer Unit [2] filled with 1% by weight aqueous sodium carbonate monohydrate solution at 85°F (30°C). The developer unit throughout rate selected was one-half that required to completely remove all resist layer from a laminated, unexposed

[2] Manufactured by E. I. du Pont de Nemours & Co., Wilmington, DE

panel, i.e., give a residence time in the developer twice the minimum. The exposure time was selected to produce a visible step 12 in a cube-root-of-two stepwedge image on a panel developed at the above conditions.

Test Procedures

Alkaline Etchant Resistance

A laminated sample (2.6 cm x 25 cm) was exposed with a target consisting of 0.006 inch (152 microns) lines and spaces. After development, the sample was lowered at a constant speed of 3.16 inch per minute (8.03 cm/min) into an alkaline etchant replenisher solution consisting of 2 Molar ammonium chloride adjusted to pH 9.2 with ammonium hydroxide. As soon as the sample was completely immersed, it was removed quickly and rinsed with water for thirty seconds. The alkaline etchant solution strips resist image from a portion of the board beginning at the end present in the solution longest and ending at that point on the board where immersion time was insufficient for stripping to occur. The distance from the unstripped end of the panel to the first absence of intact coating was measured. From this measurement, and the known immersion rate, the immersion time for the image at that break point was calculated. This is the length of time the coating could resist the stripping action of the etchant.

Results from tests on the coatings are listed in Table III.

TABLE III

| ALKALINE ETCHANT RESISTANCE | |
| --- | --- |
| Coating | Resistance Time |
| 1A (Control) | 48 sec |
| 1B | 92 sec |
| 1C | 73 sec |

Values of "Alkaline Etchant Resistant Improvement" (AERI) were derived based on the following equation:

$$AERI = [(AER_{sample} - AER_{control})/AERcontrol] \times 100$$

giving results for these coatings shown in Table IV.

TABLE IV

| ALKALINE ETCHANT RESISTANCE IMPROVEMENT | |
| --- | --- |
| Coating | Percent Improvement |
| 1A | Control |
| 1B | 92% |
| 1C | 52% |

Tenting Strength

8

Samples of each coating were laminated to copper clad board containing an array of holes each 0.175 inch (4.45 mm) in diameter. After exposure and development, the number of unbroken holes was counted and the percent of the holes remaining intact was calculated. Results were:

TABLE V

| TENTING PERFORMANCE | |
| --- | --- |
| Coating | Percent Holes Intact |
| 1A (Control) | 62% |
| 1B | 98% |
| 1C | 49% |

Values of "Tenting Improvement" (TI) were calculated by the following equation

$$TI = [(\% \text{ intact}_{sample} - \% \text{ intact}_{control})/\% \text{ intact}_{control}] \times 100$$

giving results for these coatings as shown:

TABLE VI

| TENTING IMPROVEMENT | |
| --- | --- |
| Coating | Percent Improvement |
| 1A | Control |
| 1B | 58% |
| 1C | -21% |

Development Latitude

Laminated samples were exposed through a target which contained fine lines of various widths. Each sample was then passed through the developer (at a throughout rate set to produce a residence time twice that required to remove the unexposed coating) for a designated number of times: once, three times, five times, and seven times. The finest line held (FLH) on each sample was recorded. Results are tabulated below:

TABLE VII

| DEVELOPMENT LATITUDE | | | |
| --- | --- | --- | --- |
| Finest Line Held After | Coating 1A | Coating 1B | Coating 1C |
| 1 Pass | 46 microns | 46 microns | 46 microns |
| 3 Passes | 56 microns | 46 microns | 46 microns |
| 5 Passes | 81 microns | 56 microns | 99 microns |
| 7 Passes | 102 microns | 76 microns | 122 microns |

"Development Latitude Improvement (DLI) was calculated by the following equation:

$$DLI = \{[(FLH_{n-p}-FLH_{1-p})_{control} -(FLH_{n-p}-FLH_{1-p})_{sample}]/(FLH_{n-p} - FLH_{1-p})_{control}) \times 100$$ [wherein -p = n number of passes and 1-p = one pass]

The results are listed below.

TABLE 8

| DEVELOPMENT LATITUDE IMPROVEMENT | | | |
|---|---|---|---|
| No. Passes | Coating 1A | Coating 1B | Coating 1C |
| 3 | Control | 100% | 100% |
| 5 | Control | 71% | -51% |
| 7 | Control | 45% | -36% |

## Summary of Results

Table IX summarizes the performance improvements demonstrated by incorporating metal compounds into an aqueous processible photoresist formulation.

TABLE IX

| SUMMARY OF IMPROVEMENTS | | | |
|---|---|---|---|
| Improvement Category | Coating 1A | Coating 1B | Coating 1C |
| Alkaline Etchant Resistance | Control | 92% | 52% |
| Tenting | Control | 58% | -21% |
| Development Latitude | | | |
| 3 Passes | Control | 100% | 100% |
| 5 Passes | Control | 71% | -51% |
| 7 Passes | Control | 45% | -36% |

The metal compounds can be miscible with the coating medium, e.g., calcium acetoacetonate in this example (Coating 1C). The results show that adding it to the formulation can improve alkaline etch resistance and development latitute (1C vs 1A). More advantageously, the metal compounds can be suspended in the coating medium as uniformly dispersed insoluble fine particles and be a part of a system which photolytically generates acid and thereby causes the formation of active polyvalent metal ions during exposure. Comparing coatings 1B and 1A shows that incorporating Multifex® MM calcium carbonate and diphenyliodonium hexafluorophosphate into the photoresist improves tenting performance as well as alkaline etch resistance and development latitude. In addition, the magnitude of improvements are substantially larger than those achieved by incorporating a miscible metal compound (1C).

## EXAMPLE 2

A stock solution of the formulation described in Table X was prepared.

TABLE X

| STOCK SOLUTION 1 | |
| --- | --- |
| Ingredient | Amount (g) |
| Benzophenone | 72.00 |
| 2,2'-Bis-(o-chlorophenyl-4,4',5,5' tetraphenylbiimidazole) | 14.40 |
| Michler's ketone | 2.88 |
| Leuco crystal violet | 4.32 |
| Trimethylolpropane triacrylate | 432.00 |
| Victoria green | 0.72 |
| Methylene chloride | 2253 |
| Methanol | 196 |

To aliquots of the stock solution, Multifex® MM calcium carbonate, acid generators and various polymers (Table XI) were added, according to the formulations listed in Table XII. Mixtures 2A and 2B were prepared with all polymers except the following: with polymer P5 and P9, coating mixtures A and C were prepared; with polymer P11, mixtures A and D were made. Mixtures 2C were also prepared using polymers P6 and P10. Results of testing are given in Table XIII.

TABLE XI

| POLYMERS EVALUATED | | | | | |
| --- | --- | --- | --- | --- | --- |
| Polymer | Chemical Composition* | Monomer Ratio | Molecular Weight x $10^{-3}$ | Acid No. | Tg |
| P1 | MMA/EA/AA | 37/55/8 | 260 | 80 | 37 |
| P2 | MMA/EA/AA | 71/17/12 | 200 | 100 | 70 |
| P3 | MMA/EA/AA | 55/38/7 | 42 | 80 | 52 |
| P4 | MMA/EA/MAA | 51/29/20 | 50 | 127 | 87 |
| P5 | S/MA/AA in | 55/20/25 | 52 | 197 | 81 |
| P6 | MMA/EA/S/AA | 40/20/15/25 | 50 | 115 | 78 |
| P7 | S/MA (partly i-BuOH ester) | 50/50 | 100 | 190 | 190 |
| P8 | S/MA (partly i-BuOH ester) | 50/50 | 200 | 210 | 210 |
| P9 | S/MA (partly PrOH ester) | 50/50 | 8 | 350 | --- |
| P10 | S/MA (partly PrOH ester) | 50/50 | 8 | 270 | 165 |
| P11 | TBEMA/AA/OAM/MMA/HPMA | 4/16/40/34/6 | 80 | 120 | 130 |

*AA = Acrylic Acid

EA = Ethyl acrylate

i-BuOH = Isobutanol

HPMA = Hydroxypropyl Methacrylate

OAM = N-(t-Octyl)Acrylamide

MA = Maleic Amhydrocloride

MAA = Methacrylic Acid

MMA = Methyl Methacrylate

PrOH = Propyl Alcohol (mixed isomers)

S = Styrene

TBEMA = t-Butylaminoethyl Methacrylate

## TABLE XIII

| FORMULATION OF COATING MIXTURES | | | | |
|---|---|---|---|---|
| Ingredient | Mixture 2A | Mixture 2B | Mixture 2C | Mixture 2D |
| Stock solution 1 | 55.00 g | 55.00 g | 55.00 g | 55.00 g |
| Polymer (Table XI) | 16.80 g | 16.80 g | 16.80 g | 16.80 g |
| FC-508[1] | -- | 0.718 g | 3.58 g | -- |
| FX-512[2] | -- | -- | -- | 0.09 g |
| Multifex® MM | -- | 1.440 g | 7.20 g | 0.19 g |

[1] A 50% solution of triphenylsulfonium hexafluorophosphate in an aromatic ester. Available from 3M Co., St. Paul, MN.

[2] A 60% solution of triphenylsulfonium hexafluorophosphate in gamma-butyrolactone. Available from 3M Co., St., Paul, MN.

The procedures described in Example 1 were followed to coat the mixtures and to evaluate the resulting coatings. Improvement in alkaline etchant resistance and development latitude of each set of samples was calculated according to the equations given in Example 1. The results (Table XIII) show that photogeneration of metal ions is effective in improving properties of aqueous processible photoresists containing acid binders and that a variety of acid binders will work satisfactorily.

## TABLE XIII

| END USE PROPERTY IMPROVEMENTS WITH RESISTS CONTAINING VARIOUS BINDERS | | |
|---|---|---|
| Polymer | Alkaline Etchant Resistance | Development Latitude |
| P1 | 7% | 6% |
| P2 | 32% | -30% |
| P3 | 32% | -53% |
| P4 | 14% | 0% |
| P5 (Mixture 2C) | 38% | -33% |
| P6 | 39% | 26% |
| P6 (Mixture 2C) | 22% | 58% |
| P7 | 14% | 56% |
| P8 | 17% | 50% |
| P9 (Mixture 2C) | 26% | 83% |
| P10 | -4% | 89% |
| P10 (Mixture 2C) | 110% | -25% |
| P11 (Mixture 2D) | 12% | -86% |

## EXAMPLE 3

Mixtures with formulations similar to Example 2 with polymer P8 were prepared; these were the controls. Test mixtures were made by adding to the control formulation Multifex® MM and an acid generator in amounts shown in Table XIV.

## TABLE XIV - COATING FORMULATIONS CONTAINING VARIOUS ACID GENERATORS

| | Acid Generator | | Multifex® |
|---|---|---|---|
| Mixture | Identity | Amount (%) | Amount (%) |
| 3A | CG-21-746[1] | 2.50 | 5.02 |
| 3A | FC-508 | 2.60 | 2.60 |
| 3C | FC-509[2] | 2.85 | 2.85 |
| 3D | FX-512 | 2.60 | 2.60 |

[1]A sulfonyloxy ketone, available from Ciba-Geigy, Oak Brook, IL, capable of liberating sulfonic acid on actinic radiation of the formula:

$$C_6H_5-\overset{\overset{\textstyle O}{\|}}{C}-\underset{\underset{\textstyle C_6H_5}{|}}{CH}-O-SO_2-R$$

[2]A solution of diphenyliodonium hexafluorophosphate (45%) in dimethylphthalate (45%) and a cycloaliphatic epoxide (10%). Available from 3M Co., St. Paul, MN.

[3]Amount (%) - Based on the amount of non-volatile components

Coatings with made and tested following the procedures described in Example 1. The results (Table XV) show that various compounds which can form acids photolytically can be used to activate the insoluble $CaCO_3$ leading to improved performance of aqueous resists.

TABLE XV

| PERFORMANCE IMPROVEMENTS OF COATINGS CONTAINING VARIOUS ACID GENERATORS | | |
|---|---|---|
| Coating | Alkaline Etchant Resistance | Development Latitude (7 Passes) |
| 3A | 26% | 43% |
| 3B | 66% | 53% |
| 3C | >69% | --- |
| 3D | 148% | 34% |

EXAMPLE 4

A stock solution formulation similar to that of Example 2 with polymer P8 was prepared. To aliquots of the stock solution, FC-508 acid generator and various insoluble metal compounds were added in the amounts listed in Table XVI.

TABLE XVI

| COATING FORMULATIONS CONTAINING VARIOUS METAL COMPOUNDS | | | |
|---|---|---|---|
| Coating | Acid Generator FC-508 (%) | Metal Compound | |
| | | Composition | Amount (%) |
| 4A | 2.6 | $CaCO_3$[1] | 2.6 |
| 4B | 2.6 | $BaO$[2] | 2.6 |
| 4C | 2.6 | $MgSO_4$[2] | 2.6 |
| 4D | 2.6 | $Al_2O_3$[2] | 2.6 |

[1]Multifex® MM
[2]Laboratory reagent grade material
[3]Amount (%) - Based on the amount of non-volatile components

The samples were prepared and tested by procedures described in Example 1. The results (Table XVII) show that various insoluble metal compounds can be used to achieve improved resist performance when used in conjunction with a material capable of photolytically generating acid.

TABLE XVII

| PERFORMANCE IMPROVEMENTS OF COATINGS CONTAINING VARIOUS METAL COMPOUNDS | | |
|---|---|---|
| Polymer | Alkaline Etchant Resistance | Development Latitude |
| 4A | 66% | 53% |
| 4B | 53% | 55% |
| 4C | 58% | 89% |
| 4D | 23% | 21% |

EXAMPLE 5

Experimental procedures described in Example 1 were generally followed for obtaining the data of the present example.

A stock solution with composition similar to that described in Table I was prepared. Coating mixtures were prepared by adding additional components to aliquots of the stock solution (Table XVIII). The mixtures were coated and test samples on copper clad boards prepared by lamination, imagewise exposure and development.

TABLE XVIII

| FORMULATION OF COATING MIXTURES | | | | | |
|---|---|---|---|---|---|
| Ingredient | Mixture 5A | Mixture 5B | Mixture 5C | Mixture 5D | Mixture 5E |
| Stock solution | 45 g | 45 g | 45 g | 45 g | 45 g |
| Multifex® MM | - | 0.45 g | 0.45 g | 1.35 g | 1.35 g |
| FC-509 | - | - | 0.90 g | 0.45 g | 1.35 g |
| | (Control) | | | | |

The control for measuring resist stripping time was as follows. The exposed/developed test sample was placed in 3% KOH at 130° F (54° C) with constant stirring. The time between immersing the sample and the resist image beginning to detach from the copper was taken as the time to strip (TTS).

The results (Table XIX) show that incorporating a metal ion photogenerating system into a photoresist containing an acid binder improves alkaline etchant resistance significantly with little or not effect on the stripping time.

TABLE XIX

| SUMMARY OF TEST RESULTS | | | | | |
|---|---|---|---|---|---|
| Test Performed | Ctng. 5A | Ctng. 5B | Ctng. 5C | Ctng. 5D | Ctng. 5E |
| Alkline Etchant Resistance (sec.) | 53.8 | 52.3 | 61.3 | 65.0 | 67.3 |
| Stripping Time (min.) | 0.86 | 0.84 | 0.85 | 0.88 | 0.86 |
| | (Control) | | | | |

## Claims

1. In a photopolymerizable composition comprising:
(a) at least one nongaseous ethylenically unsaturated compound having a boiling point above 100° C at normal atmospheric pressure and being capable of forming a high polymer of photoinitiated addition polymerization,
(b) an initiating system activated by actinic radiation, and
(c) a preformed macromolecular acid binder containing carboxylic acid groups, whereby the composition is capable of development in an aqueous sodium carbonate solution containing one percent by weight sodium carbonate, said development allowing removal of the photopolymerizable composition without removal of a photopolymerizable material resulting from the photopolymerizable composition
wherein the improvement comprises incorporation into said composition a substantially insoluble metal compound and a precursor to an acid whereby the precursor will photolytically form an acid upon exposure of said composition to actinic radiation of sufficient intensity and duration to polymerize said composition, whereby the metal compound reacts with the photolytically generated acid to form soluble multivalent metal ions which are capable of reacting with the carboxylic acid groups of the binder.

2. The composition of claim 1 wherein the said binder has an acid number of at least 50 and a pKa not greater than 11 measured in acetone.

3. The composition of claim 2 wherein the acid binder has an acid number in a range from 80 to 400 and a pKa in a range from 5 to 11.

4. The composition of claim 1 wherein the insoluble metal compound is calcium carbonate, barium oxide, magnesium sulfate or aluminum oxide.

5. The composition of claim 1 wherein the insoluble metal compound is present in a range of 0.05 to 20% by weight of the composition.

6. The composition of claim 5 wherein the insoluble metal compound is present in a range of 2.5 to 10% by weight of the composition.

7. The composition of claim 1 wherein the acid precursor generates hexafluorophoric acid or sulfonic acid.

8. The composition of claim 7 wherein the acid precursor is hexofluorophosphate or a sulfonate which can photolytically form hexafluorophosphoric acid or sulfonic acid.

9. The composition of claim 8 wherein the acid precursor is diphenyliodonium hexafluorophosphate or triphenylsulfonium hexafluorophosphate.

10. The composition of claim 1 wherein the acid precursor is present in an amount of at least 0.025% by weight of the composition.

11. The composition of claim 10 wherein the acid precursor is present in an amount in a range of 1 to 5% of the composition.

12. A process for laminating a photosensitive composition to a substrate which is subsequently modified comprising the steps of:

(a) laminating to the substrate a supported solid photosensitive film.

(b) imagewise exposing the layer to actinic radiation,

(c) removing unexposed areas of the layer to form resist areas,

(d) permanently modifying areas of the substrate which are unprotected by the resist areas by etching the substrate or by depositing a material onto the substrate with the photopolymerizable composition comprising:

(1) at least one nongaseous ethylenically unsaturated compound having a boiling point have 100°C at normal atmospheric pressure and being capable of forming a high polymer of photoinitiated addition polymerization,

(2) an initiating system activated by actinic radiation, and

(3) a preformed macromolecular acid binder containing carboxylic acid groups, whereby the composition is capable of development in an aqueous sodium carbonate solution containing one percent by weight sodium carbonate, said development allowing removal of the photopolymerizable composition without removal of a photopolymerized material resulting from the photopolymerizable composition

wherein the improvement comprises incorporation into said composition a substantially insoluble metal compound and a precursor to an acid whereby the precursor will photolytically form an acid upon exposure of said composition to actinic radiation of sufficient intensity and duration to polymerize said composition, whereby the metal compound reacts with the photolytically generated acid to form soluble multivalent metal ions which are capable of reacting with the carboxylic acid groups of the binder.